# EUROPÄISCHE PATENTSCHRIFT

(11) **EP 1 587 705 B1**
(45) Veröffentlichungstag und Bekanntmachung des Hinweises auf die Patenterteilung: **15.06.2011**
(21) Anmeldenummer: 03789252.8
(22) Anmeldetag: 12.12.2003
(51) Int. Cl.: B60L 11/00

(54) **INTEGRIERTES BAUELEMENT**
INTEGRATED COMPONENT
COMPOSANT INTEGRE

(30) Priorität: 13.01.2003 DE 10301008
(43) Veröffentlichungstag der Anmeldung: 26.10.2005
(73) Patentinhaber: Continental Teves AG & Co. oHG, 60488 Frankfurt am Main (DE)
(72) Erfinder: FEY, Wolfgang, 65527 Niedernhausen (DE); ENGELMANN, Mario, 61449 Steinbach/Ts. (DE); HÖLZL, Gunther, 55128 Mainz (DE)
(86) Internationale Anmeldenummer: PCT/EP2003/014155
(87) Internationale Veröffentlichungsnummer: WO 2004/062958

(56) Entgegenhaltungen:
- DE-A- 19 631 627
- US-A- 6 054 780
- US-A1- 2002 121 664
- US-A1- 2002 175 661

## Beschreibung

Die Erfindung bezieht sich auf ein integriertes Bauelement, welches insbesondere in einem integrierten Schaltkreis zur Ansteuerung von Lasten in elektronischen Reglern von Kraftfahrzeugbremsen vorgesehen sein kann.

Zur Regelung der Bremsen eines Kraftfahrzeugs kann ein elektronisches Bremssystem vorgesehen sein, bei dem über integrierte Schaltkreise unter anderem individuellen Bremsen zugeordnete Ventilspulen mittels Feldeffekttransistoren angesteuert werden. Bei Fehlfunktionen eines derartigen Systems ist üblicherweise aufgrund seiner hohen Relevanz für die Fahrsicherheit eine Sicherheitsabschaltung erforderlich. Um deren Zuverlässigkeit in besonders hohem Maße zu gewährleisten, sind ihre Funktionskomponenten üblicherweise durch redundante Schaltkreise zusätzlich abgesichert. Beispielsweise ist ein Treiberausgang eines derartigen Systems, der zur Aktivierung der Spannungsversorgung der genannten Ventilstufen vorgesehen ist, üblicherweise derart verschaltet, dass er im Bedarfsfall durch zwei komplett redundant ausgeführte Abschaltpfade auf Masse gezogen werden kann.

Derartige redundante Abschaltpfade werden in integrierten Schaltkreisen eingesetzt, die in ein außerhalb eines Leistungstreiber-ICs (PCU) angeordneten Fehlerüberwachungs-IC (FMON), welches Spannungen überwacht, integriert sein können. Geraten die überwachten Spannungen außerhalb des spezifizierten Bereiches, wird ein Abschalttransistor über einen Inverter aktiviert. Das FMON-IC besteht in der Regel aus zwei getrennten Blöcken, so dass bei Zerstörung eines dieser Blöcke der zweite Block ein sicheres Abschalten gewährleistet.

Die Abschaltpfade in einer derartigen Anordnung sind üblicherweise ungeschaltet aktiv, d. h., ein so genannter "Pulldown"-Transistor wird von einer konstanten Spannung durchgeschaltet, wobei ein weiterer Transistor von einem so genannter "Pulldown"-Deaktivierungssignal angesteuert wird und dabei die Versorgung des "Pulldown"-Transistors auf Masse zieht. Gerade bei der Anwendung in Kraftfahrzeug-Bremssystemen sind in derartigen Schaltungen aus Sicherheitsgründen die Abschaltpfade vollständig redundant ausgelegt, wobei insbesondere auch die genannten "Pulldown"-Transistoren über unterschiedliche Spannungversorgungen bespeist sind. Problematisch kann in einer derartigen Schaltung aber sein, falls bei einem der Abschaltpfade ein Kurzschluss zur Spannungsversorgung auftritt. Dies könnte auch die Funktionsfähigkeit des zweiten Abschaltpfades gefährden, da dieser im Bedarfsfall, also zur funtkionsgerechten Abschaltung des Treiberausgangs, auch die Spannungsver-sorgung auf Masseniveau ziehen müsste. Um dies zu vermeiden, sind die redundanten Abschaltpfade üblicherweise jeweils durch Dioden voneinander entkoppelt.

Eine derartige Absicherung der Abschaltpfade über Dioden bedingt jedoch einen erhöhten Herstellungs- und Montageaufwand, sowie aufgrund des Spannungsabfalls über die Dioden eine Reduktion des "Pulldown"-Effekts.

Zur Verminderung von Störsignalen schlägt das Dokument US2002121664 die monolithische Integration von Treibschaltung, Schutzschaltung und Leistungstransistoren vor. Hierzu wird der Source- bzw. Anoden-Kontakt und der Drain- bzw. Kathoden-Kontakt des Leistungstransistors jeweils über getrennten Shield-Gebieten innerhalb des Substrats gezogen, wobei der Anoden-Kontakt mit dem Substrat elektrisch verbunden ist. Als Shield werden p-n-Übergänge bezeichnet, die z.B. durch SOI-Implantation durch den Silizumfilm und das vergrabene Oxid hindurch hergestellt werden können. Dabei liegen die Anode bzw. der Source- und der Gate-Kontakt eines Treiber-Transistors sowie die Kathode bzw. der Drain-Kontakt auf zwei unterschiedlichen und gegeneinander floatenden Shield-Gebieten. Dadurch wird die Raumladungszone nicht nur im dünnen Siliziumfilm und im vergrabenen Oxid abgebaut, sondern auch im Substrat. Der Source-Kontakt des Treiber-Transistors liegt auf Masse, die jedoch ausserhalb der integrierten Schaltung definiert ist. Trotz der monolithischen Integration entstehen dabei zwischen den Treiber-Transistoren und den Leistungs-Transistoren parasitäre Strukturen, die Störsignale übertragen können.

Der Erfindung liegt daher die Aufgabe zugrunde, ein insbesondere zum Einsatz zum An- oder Abschalten von Lasttreibern in einem Kraftfahrzeug-Bremssystem aus Sicherheitsgründen geeignetes integriertes Bauelement mit einer Anzahl von Halbleiterschaltelementen anzugeben, bei dem bei besonders einfach gehaltener Bauweise eine besonders hohe betriebliche Sicherheit gewährleistet ist.

Diese Aufgabe wird erfindungsgemäß nach Anspruch 1 dadurch gelöst, dass den Halbleiterschaltelementen zugeordnete Ansteuerleiterbahnen von auf Massepotential gehaltenen Schutzzonen umgeben sind.

Die Erfindung geht dabei von der Überlegung aus, dass für eine besonders hohe betriebliche Sicherheit des integrierten Bauelements Querauswirkungen von Kurzschlüssen bei den zur Sicherheitsabschaltung vorgesehenen Halbleiterschaltelementen auf dazu redundant geschaltete weitere Halbleiterschaltelemente konsequent vermieden werden sollten. Um dies auf besonders einfache Weise zu erreichen und insbesondere den Einsatz dazu vorgesehener Entkoppel-Dioden entbehrlich zu machen, sollte die Leitungsführung zur Ansteuerung der Halbleiterbauelemente besonders sicher gegenüber einem derartigen Übersprechen oder Kurzschluss ausgeführt sein. Dies ist erreichbar, indem die den als besonders sicherheitsrelevant eingestuften Halbleiterbauelementen zugeordneten Anschlussleiterbahnen, wie beispielsweise Gate-, Drain- oder Source-Anschluss-Leiterbahnen, in der Art einer geschirmten, von einem Schutzleiter umgebenen Zuleitung ausgeführt sind. Dazu sind die jeweiligen Anschluss-leiterbahnen von geeignet gewählten und dimensionierten Schutzzonen umgeben.

Bei den Schutzzonen kann es sich dabei insbesondere um Leiter, leitende Flächen oder leitende Bahnen handeln, die der zu schützenden Anschlussleiterbahn unmittelbar benachbart geführt sind und auf einem geeigneten Bezugspotential gehalten werden. Bei der Anordnung der Halbleiterbau-elemente in integrierter Bauweise auf einem Substrat können die Schutzzonen dabei insbesondere auch in benachbarten Lagen angeordnete, geeignet dimensionierte und positionierte leitfähige Bereiche umfassen.

Vorteilhafterweise ist für eine besonders hohe betriebliche Sicherheit der gesamte den jeweiligen Halbleiterschaltelementen zugeordnete Anschlussbereich in der Art einer geschirmten Zuleitung ausgeführt. Dazu sind vorteilhafterweise mit den Ansteuerleiterbahnen verbundene Anschlussdrähte von auf dem Bezugspotential haltbaren Schutzdrähten umgeben, wobei in alternativer oder zusätzlicher vorteilhafter Weiterbildung die mit den Ansteuerleiterbahnen ggf. verbundenen Steckerkontakte in einem gemeinsamen Steckergehäuse zu auf dem Bezugspotential gehaltenen Steckerkontakten benachbart angeordnet sind. Weiterhin ist zweckmäßigerweise jedes der Halbleiterschaltelemente an sich von einer auf dem Bezugspotential haltbaren Schutzzone umgeben und somit geschirmt ausgeführt.

Bei einer derartigen Anordnung und einer Ausgestaltung des Halbleiterschaltelements als Transistor ist die Steuerleitung (Gate) vorteilhafterweise auf dem kürzesten Weg und in möglichst großem Abstand zu Drain- und Source-Anschlüssen aus der das Halbleiterbauelement umgebenden Schutzzone herausgeführt. Der Gate-Anschluss ist dabei in weiterer vorteilhafter Ausgestaltung durch einen geeignet gewählten Widerstand strombegrenzt ausgeführt.

Eine besonders hohe betriebliche Sicherheit ist erreichbar, indem als Bezugspotential vorteilhafterweise Massepotential vorgesehen ist. Die Aufrechterhaltung von Massepotential auf den Schutzzonen ist dabei in besonders einfacher Weise erreichbar, indem diese geeignet und dauerhaft mit Masseleitung verbunden sind.

Um eine hohe betriebliche Sicherheit zu gewährleisten, sind die Halbleiterschaltelemente vorteilhafterweise redundant ausgeführt. In alternativer oder zusatzlicher vorteilhafter Weiterbildung sind die Halbleiterschaltelemente stromlos offen geschaltet.

Die mit der Erfindung erzielten Vorteile bestehen insbesondere darin, dass durch die Ausführung der Zuleitungen zu den zur Sicherheitsabschaltung vorgesehenen Halbleiterschaltelementen als geschirmte, von einem Schutzleiter umgebene Zuleitungen eine besonders hohe auslegungsbedingte Sicherheit gegen eine Querbeeinflussung von Kurzschlüssen zwischen den redundant ausgeführten Abschaltpfaden erreichbar ist. Dabei ist zur Gewährleistung einer hohen betrieblichen Sicherheit eine zusätzliche Absicherung durch externe Entkoppel-Dioden nicht erforderlich, so dass das integrierte Bauelement vergleichsweise einfach ausgeführt sein kann.

Ein Ausführungsbeispiel der Erfindung wird anhand einer Zeichnung näher erläutert. Darin zeigen:
- Fig. 1: ein integriertes Bauelement, insbesondere zur An- wendung in elektronischen Reglern von Kraftfahr- zeugbremssystemen, und
- Fig. 2: schematisch einen Anschlussbereich des Bauelements nach Fig. 1.

Gleiche Teile sind in beiden Figuren mit denselben Bezugszeichen versehen.

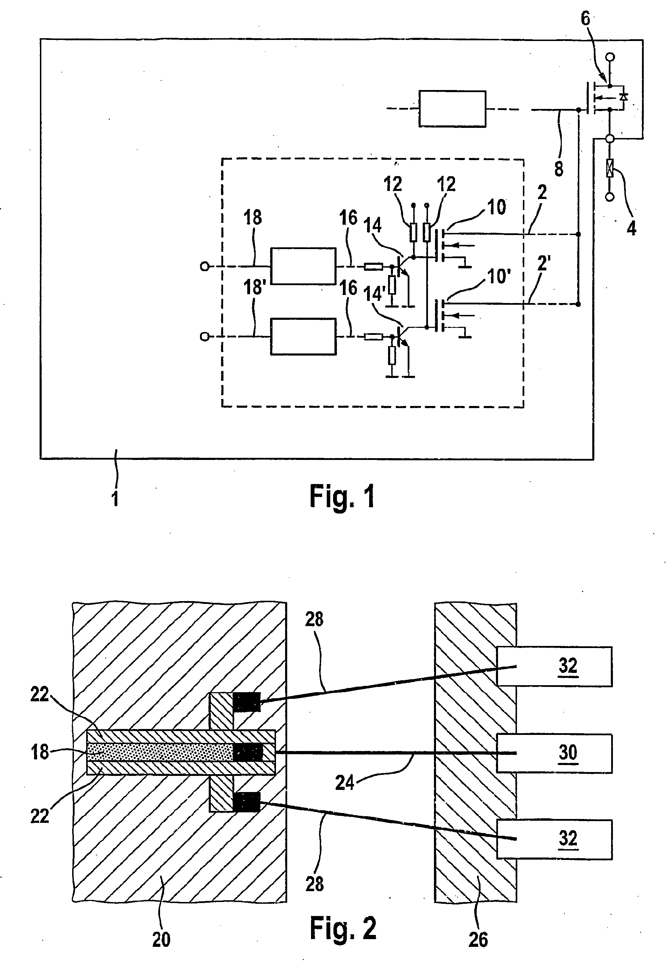

Das in Fig. 1 schematisch und auszugsweise dargestellte integrierte Bauelement 1 ist zur bedarfsweisen Abschaltung der Spannungsversorgung von einer Bremse eines Kraftfahrzeugs zugeordneten Ventilstufen aus Sicherheitsgründen vorgesehen. Dazu umfasst das integrierte Bauelement 1 redundant ausgeführte Abschaltpfade 2, 2', über die ein zur Aktivierung der Spannungsversorgung des den Ventilstufen 4 zugeordneten Treibers 6 vorgesehener Treiberausgang 8 im Bedarfsfall auf Masse gezogen werden kann. Die Lasttreiber, die Lasten und die Abschaltstufen können selbstverständlich auch mehrfach vorhanden sein.

Die Abschaltpfade 2, 2' sind ungeschaltet aktiv und umfassen zur bedarfsweisen Durchführung einer Schaltfunktion jeweils ein als so genannter "Pulldown"-Transistor ausgeführtes Halbleiterschaltelement 10, 10'. Diese werden von einer konstanten Spannung 12 durchgeschaltet. Den Halbleiterschaltelementen 10, 10' ist jeweils innerhalb ihres Abschaltpfads 2, 2' ein ebenfalls als Transistor ausgeführtes, weiteres Halbleiterschaltelement 14, 14' vorgeschaltet, das im Bedarfsfall von einem "Pulldown"-Deaktivierungssignal 16 angesteuert wird und dabei die Transistorversorgung auf Masse zieht. Der Transistor schließt demzufolge, so dass der "Pulldown" deaktiviert ist.

Aus Sicherheitsgründen sind die Abschaltpfade 2, 2' vollständig redundant ausgeführt, wobei insbesondere die als Transistoren ausgeführten Halbleiterschaltelemente 10, 10' mit unabhängigen, redundant ausgeführten Spannungsversorgungen beaufschlagt sind.

Für eine besonders hohe betriebliche Sicherheit ist die Redundanz der Abschaltpfade 2, 2' konsequent eingehalten. Dabei sind die Abschaltpfade 2, 2' auch gegen ein Übersprechen von Kurzschlüssen gegen Versorgungspotential abge-sichert. Um dies mit einfacher Bauweise und insbesondere unter Verzicht auf die Verwendung externer Entkoppel-Dioden zu gewährleisten, sind die den Halbleiterschaltelementen 14, 14' zugeordneten Anschlussleiterbahnen 18, 18' in der Art geschirmter Leiter ausgeführt.

Dazu sind, wie dies im Ausschnitt nach Fig. 2 erkennbar ist, die auf einem auch die Halbleiterschaltelemente 10, 10', 14, 14' tragenden Substrat 20 angeordneten Anschlussleiterbahnen 18, 18' von Schutzzonen 22 umgeben. Die Schutzzonen 22, die die Funktion eines Schutzleiters erfüllen, sind dabei zu den Anschlussleiterbahnen 18 benachbart geführt und in der Bestückungsebene der Anschlussleiterbahnen 18 angeordnet. Um zudem auch eine Absicherung in Richtung orthogonal zur in Fig. 2 gezeigten Bestückungsebene zu gewährleisten, sind die Anschlussleiterbahnen 18 auch in benachbarten Bestückungsebenen von geeignet gewählten Schutzzonen umgeben.

Die Schutzzonen 22 sind auf Masse als Bezugspotential haltbar. In der Art einer vollständigen Schirmung ist aber auch der der Anschlussleiterbahn 18 zugeordnete Anschlussdraht 24, der vom Substrat 20 zum Leadframe 26 führt, von auf Masse als Bezugspotential haltbaren Schutzdrähten 28 umgeben. In nicht näher dargestellter Weise sind zudem die Halbleiterbauelemente 14, 14' von auf Masse als Bezugspotential haltbaren Schutzzonen umgeben.

Die mit den Ansteuerleiterbahnen 18, 18' verbundenen Steckerkontakte 30 sind zudem in einem gemeinsamem Steckergehäuse zu auf Masse als Bezugspotential gehaltenen Steckerkontakten 32 benachbart angeordnet, so dass das gesamte, sich vom Steckerkontakt 30 über den Anschlussdraht 24 bis zur Anschlussleiterbahn 18 erstreckende Zuleitungssystem geschirmt ausgeführt ist.

Die insbesondere als so genannte MD-OFF-Transistoren vorgesehenen Halbleiterbauelemente 14, 14' sind von einem nicht näher dargestellten Massering als weitere Schutzzone umgeben. Zusätzlich ist es zweckmäßig, die Steuerleitung (Gate) auf dem kürzesten Weg und in möglichst großem Abstand zu Drain- und Source-Anschlüssen aus diesem Ring herauszuführen.

Der Gate-Anschluss der als Transistor ausgeführten Halbleiterschaltelemente 10, 10' ist bevorzugt durch einen Widerstand strombegrenzt, so dass im Fehlerfall erhöhte Sicherheit gewährleistet ist. Bei den Transistoren handelt es sich vorzugsweise um NMOS-Feldeffekttransistoren.

Der "Pulldown"-Widerstand der Halbleiterschaltelemente 10, 10' ist dabei derart gering gewählt, dass mit der vorgesehenen Strombegrenzung der jeweils redundante Schaltpfad einen solchen Strom sowie die entsprechende Leitung auf Masse ziehen kann.

### Bezugszeichenliste

- 1: Bauelement
- 2, 2': Abschaltpfade
- 4: Ventilstufen
- 6: Treiber
- 8: Treiberausgang
- 10, 10': Halbleiterschaltelement
- 12: Spannung
- 14, 14': Halbleiterschaltelement
- 16: "Pulldown"-Deaktivierungssignal
- 18, 18': Anschlussleiterbahn
- 20: Substrat
- 22: Schutzzone
- 24: Anschlussdraht
- 26: Leadframe
- 28: Schutzdrähte
- 30, 32: Steckerkontakte

## Patentansprüche

1. Integriertes Bauelement (1) mit einer Anzahl von Halbleiterschaltelementen (10, 10', 14, 14') zum An- oder Abschalten von Lasttreibern (6) aus Sicherheitsgründen, **dadurch gekennzeichnet, dass** den Halbleiterschaltelementen (10, 10', 14, 14') zugeordnete Ansteuerleiterbahnen (2, 2', 18, 18') von auf Massepotential gehaltenen Schutzzonen (22) umgeben sind.

2. Integriertes Bauelement (1) nach Anspruch 1, **dadurch gekennzeichnet, dass** mit den Ansteuerleiterbahnen (2, 2', 18, 18') verbundene Anschlussdrähte (24) von auf dem Bezugspotential haltbaren Schutzdrähten (28) umgeben sind.

3. Integriertes Bauelement (1) nach Anspruch 1 oder 2, **dadurch gekennzeichnet, dass** jedes der Halbleiterschaltelemente (10, 10', 14, 14') von einer auf dem Bezugspotential haltbaren Schutzzone (22) umgeben ist.

4. Integriertes Bauelement (1) nach einem der Ansprüche 1 bis 3, **dadurch gekennzeichnet, dass** die mit den Ansteuerleiterbahnen (2, 2', 18, 18') verbundenen Steckerkontakte (30, 32) in einem gemeinsamen Steckergehäuse zu auf dem Bezugspotential gehaltenen Steckerkontakten (30, 32) benachbart angeordnet sind.

5. Integriertes Bauelement (1) nach einem der Ansprüche 1 bis 4, **dadurch gekennzeichnet, dass** als Bezugspotential Massepotential vorgesehen ist.

6. Integriertes Bauelement (1) nach einem der Ansprüche 1 bis 5, **dadurch gekennzeichnet, dass** die Halbleiterschaltelemente (10, 10', 14, 14') redundant ausgeführt sind.

7. Integriertes Bauelement (1) nach einem der Ansprüche 1 bis 6, **dadurch gekennzeichnet, dass** die Halbleiterschaltelemente (10, 10', 14, 14') stromlos offen geschaltet sind.

8. Integriertes Bauelement (1) nach einem der Ansprüche 1 bis 7, **dadurch gekennzeichnet, dass** den Halbleiterschaltelementen (10, 10', 14, 14') zugeordnete Steuerletiungen strombegrenzt sind.

## Claims

1. Integrated component (1) comprising a number of semiconductor switching elements (10, 10', 14, 14') for switching load drivers (6) on or off for safety reasons, **characterized in that** driving conductor tracks (2, 2', 18, 18') assigned to the semiconductor switching elements (10, 10', 14, 14') are surrounded by protective zones (22) held at earth potential.

2. Integrated component (1) according to Claim 1 **characterized in that** connection wires (24) connected to the driving conductor tracks (2, 2', 18, 18') are surrounded by protective wires (28) that can be held at the reference potential.

3. Integrated component (1) according to Claim 1 or 2, **characterized in that** each of the semiconductor switching elements (10, 10', 14, 14') is surrounded by a protective zone (22) that can be held at the reference potential.

4. Integrated component (1) according to any of Claims 1 to 3, **characterized in that** the plug contacts (30, 32) connected to the driving conductor tracks (2, 2', 18, 18') are arranged adjacent to plug contacts (30, 32) held at the reference potential in a common plug housing.

5. Integrated component (1) according to any of Claims 1 to 4, **characterized in that** earth potential is provided as the reference potential.

6. Integrated component (1) according to any of Claims 1 to 5, **characterized in that** the semiconductor switching elements (10, 10', 14, 14') are embodied in redundant fashion.

7. Integrated component (1) according to any of Claims 1 to 6, **characterized in that** the semiconductor switching elements (10, 10', 14, 14') are switched to be opened with zero current.

8. Integrated component (1) according to any of Claims 1 to 7, **characterized in that** control lines assigned to the semiconductor switching elements (10, 10', 14, 14') are current-limited.

## Revendications

1. Composant intégré (1) qui présente plusieurs éléments semi-conducteurs (10, 10', 14, 14') qui branchent et débranchent des pilotes de charge (6) pour des raisons de sécurité,
**caractérisé en ce que**
des pistes conductrices pilotes (2, 2', 18, 18') associées aux éléments semi-conducteurs (10, 10', 14, 14') sont entourées par des zones de protection (22) maintenues à un potentiel de masse.

2. Composant intégré (1) selon la revendication 1, **caractérisé en ce que** des fils de raccordement (24) reliés aux pistes conductrices pilotes (2, 2', 18, 18') sont entourés par des fils de protection (28) qui peuvent être maintenus au potentiel de référence.

3. Composant intégré (1) selon les revendications 1 ou 2, **caractérisé en ce que** chacun des éléments semi-conducteurs (10, 10', 14, 14') est entouré par une zone de protection (22) qui peut être maintenue au potentiel de référence.

4. Composant intégré (1) selon l'une des revendications 1 à 3, **caractérisé en ce que** les fiches de contact (30, 32) reliées aux pistes conductrices pilotes (2, 2', 18, 18') sont disposées dans un boîtier de fiche commun au voisinage des fiches de contact (30, 32) maintenues au potentiel de référence.

5. Composant intégré (1) selon l'une des revendications 1 à 4, **caractérisé en ce que** le potentiel de référence est le potentiel de masse.

6. Composant intégré (1) selon l'une des revendications 1 à 5, **caractérisé en ce que** les éléments semi-conducteurs (10, 10', 14, 14') sont redondants.

7. Composant intégré (1) selon l'une des revendications 1 à 6, **caractérisé en ce que** les éléments semi-conducteurs (10, 10', 14, 14') sont ouverts en l'absence de courant.

8. Composant intégré (1) selon l'une des revendications 1 à 7, **caractérisé en ce que** des conducteurs de commande associés aux éléments semi-conducteurs (10, 10', 14, 14') sont limités en courant.
